# EUROPEAN PATENT SPECIFICATION

(11) **EP 4 254 719 B1**
(45) Date of publication and mention of the grant of the patent: **06.08.2025**
(21) Application number: 22878986.3
(22) Date of filing: 07.10.2022
(51) Int. Cl.: H02J 7/00, G01R 31/382, H01M 10/48, G01R 31/367

(54) **METHOD FOR DETERMINING CHARGING PROFILE OF BATTERY AND BATTERY CHARGING SYSTEM USING SAME**
VERFAHREN ZUR BESTIMMUNG DES LADEPROFILS EINER BATTERIE UND BATTERIELADESYSTEM DAMIT
PROCÉDÉ DE DÉTERMINATION D'UN PROFIL DE CHARGE D'UNE BATTERIE ET SYSTÈME DE CHARGE DE BATTERIE L'UTILISANT

(30) Priority: 07.10.2021 KR 20210133409
(43) Date of publication of application: 04.10.2023
(73) Proprietor: LG Energy Solution, Ltd., Seoul 07335 (KR)
(72) Inventor: NAM, Gi-Min, Daejeon 34122 (KR); KIM, Hyeong-Seok, Daejeon 34122 (KR); LEE, Guang-Ri, Daejeon 34122 (KR); HWANG, Tae-Hyun, Daejeon 34122 (KR)
(74) Representative: Plasseraud IP
(86) International application number: PCT/KR2022/015222
(87) International publication number: WO 2023/059165

(56) References cited:
- JP-A- 2009 181 907
- JP-A- 2009 181 907
- KR-A- 20120 052 347
- KR-A- 20190 045 736
- KR-A- 20210 045 706
- KR-A- 20210 099 939
- US-A1- 2021 036 534
- US-A1- 2023 046 633

## Description

### TECHNICAL FIELD

The present disclosure relates to a method for determining a charging profile of a battery and a battery charging system using the same, and more particularly, to a method for determining a charging profile of a battery based on negative electrode surface potential and a battery charging system using the same.

The present application claims priority to Korean Patent Application No. 10-2021-0133409 filed on October 7, 2021 in the Republic of Korea.

### BACKGROUND ART

Recently, as the environmental pollution issue of fossil fuel becomes more serious, attention is paid to electric vehicles using batteries as a source of power.

Lithium secondary batteries are widely used as batteries for electric vehicles due to their energy density, capacity and power advantages.

Short charging time is one of challenges in electric vehicle applications. Fast charging is done by supplying large currents to batteries for a short time. The fast charging of lithium secondary batteries may cause lithium deposition on the negative electrode surface. The lithium deposition may cause serious side reactions that accompany heating between electrolytes and lithium, and this may result in fires or explosions in the batteries.

To address this problem, it is general to conservatively set a charging profile applied during fast charging. Here, the charging profile defines a current rate (C-rate) of a charging current according to the State Of Charge (SOC) of batteries. Typically, a step charging profile may be an example of the charging profile.

In the step charging profile, as the SOC of the battery increases, the C-rate of the charging current gradually decreases. The step charging profile is a charging protocol considering that as the SOC increases, the amount of lithium intercalation at the negative electrode increases, and the likelihood of lithium deposition increases as much. If the C-rate of the charging current gradually decreases, the lithium deposition at the negative electrode surface may be prevented by securing time allowing lithium diffusion into the negative electrode.

The conventional charging profiles have been aimed at preventing lithium deposition. Accordingly, there is a limit in reduction of the charging time. That is, despite the low likelihood of lithium deposition at the negative electrode, the charging current is reduced beforehand, so the increases in SOC per unit time notably slows down as it goes toward the latter stage of charging.

Accordingly, there are many needs for charging profiles for reducing the charging time in the latter stage of charging without lithium deposition at the negative electrode during the charging of lithium secondary batteries in the technical field pertaining to the present disclosure.

US2023/046633 A1 relates to the detection of lithium plating at the negative electrode of a battery.

### DISCLOSURE

### Technical Problem

The present disclosure is designed under the above-described background, and therefore the present disclosure is directed to providing a method for determining a charging profile based on negative electrode surface potential for reducing the charging time required for full charge by increasing charging rate at the latter stage of charging through increasing a current rate (C-rate) of a charging current more than the related art without lithium deposition at the negative electrode.

The present disclosure is further directed to providing a battery charging system for charging batteries using the charging profile based on the negative electrode surface potential according to the present disclosure.

### Technical Solution

To solve the above-described technical problem, in a first aspect, there is provided a method for determining a charging profile of a battery according to claim 1.

Preferably, the test unit cell may be a 4-pole cell. The 4-pole cell may include at least one positive electrode and at least one negative electrode; a reference electrode to provide a reference potential for the surface potential of the negative electrode; and a negative electrode surface potential measurement electrode in contact with the surface of the negative electrode.

Preferably, the step (a) may include (a1) determining the negative electrode surface potential profile according to SOC by measuring a negative electrode surface potential through the reference electrode and the negative electrode surface potential measurement electrode during the CC charging of the test unit cell; (a2) measuring an internal resistance present in a negative electrode surface potential measurement pathway; and (a3) correcting the negative electrode surface potential profile using a voltage component due to the internal resistance.

In an embodiment, the internal resistance may be determined by electrochemical impedance spectroscopy (EIS).

Preferably, the step (a3) may include correcting the negative electrode surface potential profile by subtracting the voltage component due to the internal resistance from the negative electrode surface potential profile.

Preferably, in the step (a), the lithium deposition boundary potential may be 0 V.

Preferably, the charging profile may be independently determined for each of a plurality of charging current C-rate and charging temperature conditions by repeatedly performing the steps (a) to (e) with varying charging current C-rate and charging temperature conditions of the CC charging.

To solve the above-described technical problem, in a second aspect, there is provided a battery charging system according to claim 8.

Preferably, the control unit may be configured to set the battery temperature measured through the temperature sensor as the charging temperature, set the charging current C-rate of the CC charging, determine a reference SOC corresponding to a lithium deposition boundary potential corresponding to the charging temperature and the charging current C-rate by referring to predefined lookup information, and perform CC charging on the battery using a charging device under the charging current C-rate condition in a charging range until the reference SOC, and in the charging range after the reference SOC, charge the battery according to the pre-determined charging profile under a condition that a voltage between the positive terminal and the negative electrode surface is kept constant.

Preferably, the control unit may be configured to determine an SOC of the battery, and determine the charging current C-rate corresponding to the SOC by referring to the charging profile, and apply a charging current corresponding to the determined charging current C-rate using the charging device to the battery.

### Advantageous Effects

According to the present disclosure, as the charging profile is determined based on the negative electrode surface potential, it is possible to reduce the charging time required for full charge compared to the related art, by increasing the charging rate at the latter stage of charging without lithium deposition.

Additionally, when the battery is charged using the charging profile of the present disclosure, it is possible to charge the battery faster than the related art without lithium deposition at the negative electrode.

### DESCRIPTION OF DRAWINGS

The accompanying drawings illustrate an exemplary embodiment of the present disclosure, and together with the following detailed description, serve to provide a further rate in the charging range after the reference SOC, wherein a decline rate of the charging current C-rate is lower than that of a CV charging condition that the voltage between the positive terminal and the negative terminal is kept constant.

Preferably, the decline rate of the C-rate may be determined such that a negative electrode surface potential of the battery corresponds to the lithium deposition boundary potential.

Preferably, the control unit may be configured to determine an SOC of the battery, and determine the charging current C-rate corresponding to the SOC by referring to the charging profile, and apply a charging current corresponding to the determined charging current C-rate using the charging device to the battery.

### Advantageous Effects

According to the present disclosure, as the charging profile is determined based on the negative electrode surface potential, it is possible to reduce the charging time required for full charge compared to the related art, by increasing the charging rate at the latter stage of charging without lithium deposition.

Additionally, when the battery is charged using the charging profile of the present disclosure, it is possible to charge the battery faster than the related art without lithium deposition at the negative electrode.

### DESCRIPTION OF DRAWINGS

The accompanying drawings illustrate an exemplary embodiment of the present disclosure, and together with the following detailed description, serve to provide a further understanding of the technical aspects of the present disclosure, and thus the present disclosure should not be construed as being limited to the drawings.
FIG. 1 is a flowchart of a method for determining a charging profile of a battery based on negative electrode surface potential according to an embodiment of the present disclosure.
FIG. 2 is a diagram showing a schematic structure of a 4-pole cell according to an embodiment of the present disclosure.
FIG. 3 is a graph showing a negative electrode surface potential profile (solid line) according to a state of charge (SOC) determined in step S40 and a negative electrode surface potential profile (dashed line) after correction of voltage component due to internal resistance in step S60 according to an embodiment of the present disclosure.
FIG. 4 is a graph showing an example of a first charging profile (dashed line) and a second charging profile (solid line) according to an embodiment of the present disclosure.
FIG. 5 is a graph showing a difference profile obtained by subtracting a first charging profile (dashed line in FIG. 4) from a second charging profile (solid line in FIG. 4) according to an embodiment of the present disclosure.
FIG. 6 is a graph showing a charging profile of a battery obtained by correction of a third charging profile based on the third charging profile obtained through constant current (CC)-constant voltage (CV) charging of a battery cell and a difference profile according to an embodiment of the present disclosure.
FIG. 7 is a diagram showing the architecture of a battery charging system according to an embodiment of the present disclosure.

### BEST MODE

Hereinafter, an exemplary embodiment of the present disclosure will be described with reference to the accompanying drawings. Prior to the description, it should be understood that the terms or words used in the specification and the appended claims should not be construed as limited to general and dictionary meanings, but interpreted based on the meanings and concepts corresponding to technical aspects of the present disclosure on the basis of the principle that the inventor is allowed to define terms appropriately for the best explanation. Therefore, the embodiments described herein and the illustrations in the drawings are just an exemplary embodiment of the present disclosure and do not fully describe the technical aspects of the present disclosure, so it should be understood that a variety of other equivalents and modifications could have been made thereto at the time of filing the patent application.

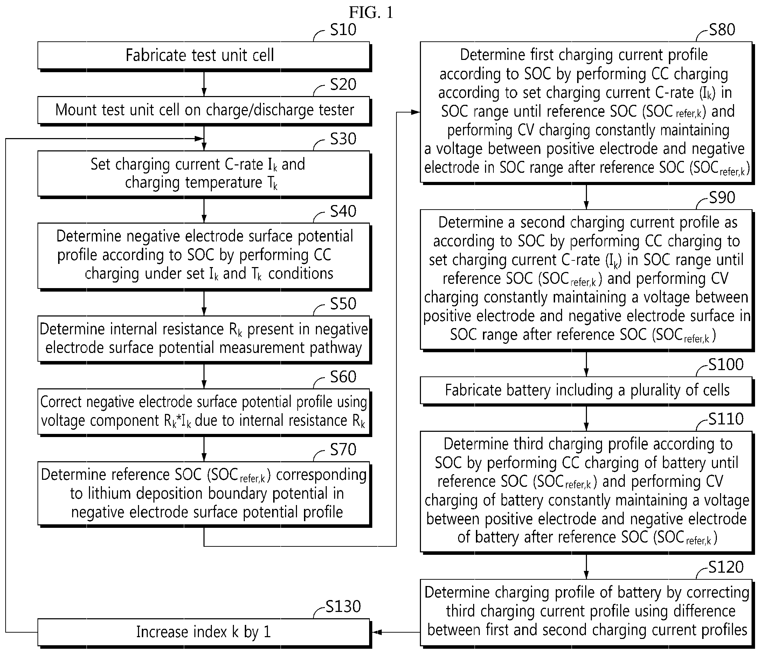

FIG. 1 is a flowchart of a method for determining a charging profile of a battery based on negative electrode surface potential according to an embodiment of the present disclosure.

Referring to FIG. 1, first, in step S10, a test unit cell is prepared. In an example, the test unit cell may be a 4-pole cell. The 4-pole cell includes at least one positive electrode and at least one negative electrode, a separator between the positive electrode and the negative electrode, a reference electrode to provide a reference potential for the negative electrode surface potential; and a negative electrode surface potential measurement electrode disposed in direct contact with the surface of the negative electrode.

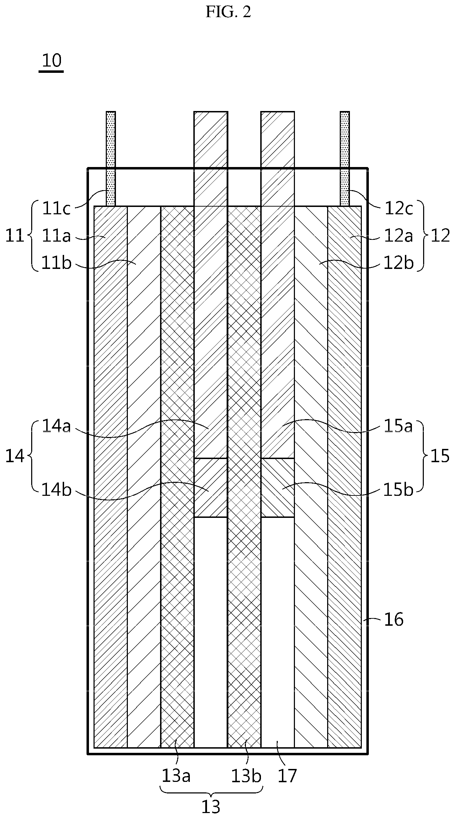

FIG. 2 is a diagram showing a schematic structure of the 4-pole cell 10 according to an embodiment of the present disclosure.

Referring to FIG. 2, the 4-pole cell 10 includes a positive electrode 11, a negative electrode 12 and two separators 13.

The positive electrode 11 includes a positive electrode current collector plate 11a, a positive electrode active material layer 11b coated on the surface of the positive electrode current collector plate 11a and a positive electrode tab 11c. The negative electrode 12 includes a negative electrode current collector plate 12a, a negative electrode active material layer 12b coated on the surface of the negative electrode current collector plate 12a and a negative electrode tab 12c.

In an example, the positive electrode current collector plate 11a may be an aluminum foil, and the negative electrode current collector plate 12a may be a copper foil. The positive electrode active material layer 11b may be a coating layer of lithium transition metal oxide including Ni, Co and Mn, and the negative electrode active material layer 12b may be a coating layer of graphite. The separator 13 may be a porous insulation film. The insulation film may be a polyolefin film, for example, polyethylene, polypropylene or the like. The separator 13 may have an inorganic coating layer including inorganic particles such as alumina (Al₂O₃) on the surface thereof.

The separator 13 includes a first separator 13a and a second separator 13b between the positive electrode 11 and the negative electrode 12. The first separator 13a is disposed on the positive electrode 11 side, and the second separator 13b is disposed on the negative electrode 12 side.

Additionally, the 4-pole cell 10 includes a reference electrode 14 between the first separator 13a and the second separator 13b to provide the reference potential for the negative electrode surface potential and a negative electrode surface potential measurement electrode 15 between the second separator 13b and the negative electrode active material layer 12b and placed in direct contact with the negative electrode surface (the negative electrode active material layer 12b.

In an example, the reference electrode 14 includes a porous wire 14a made of Cu and a LTO (LiTiO₂) layer 14b having a predetermined thickness at the end of the porous wire 14a. Additionally, the negative electrode surface potential measurement electrode 15 includes a porous wire 15a made of Cu and a Cu layer 15b having a predetermined thickness at the end of the porous wire 15a.

After the components of the 4-pole cell 10 are received in a packaging 16, the packaging 16 may be sealed up. In an example, the packaging 16 may be a pouch film. In this case, the packaging 16 may be heat-welded along the edges.

The positive electrode tab 11c, the negative electrode tab 12c, the porous wire 14a of the reference electrode 14 and the porous wire 15a of the negative electrode surface potential measurement electrode 15 of the 4-pole cell 10 may be exposed through the packaging 16. Additionally, an electrolyte 17 necessary for the operation of the 4-pole cell 10 may be injected into the packaging 16.

Meanwhile, since the present disclosure is characterized by determining the charging profile, it is obvious to those skilled in the art that the type of the component or material of the 4-pole cell 10 may change depending on the type of the test unit cell.

Referring back to FIG. 1, after the step S10, step S20 is performed. In the step S20, the test unit cell is mounted on a charge tester.

Preferably, the charge tester includes a constant temperature die to maintain the temperature of the test unit cell at a set temperature, and the test unit cell may be mounted on the constant temperature die.

Subsequently, in step S30, a charging current C-rate Iₖ and a charging temperature Tₖ of constant current (CC) charging as the charging/discharging conditions of the test unit cell are set. The charging temperature Tₖ corresponds to the temperature of the test unit cell.

Subsequently, in step S40, a negative electrode surface potential profile according to SOC is determined by measuring the negative electrode surface potential through the reference electrode 14 and the negative electrode surface potential measurement electrode 15 during CC charging of the test unit cell under the charging temperature Tₖ and charging current C-rate Iₖ conditions.

Subsequently, in step S50, an internal resistance Rₖ present in the negative electrode surface potential measurement pathway is determined. The internal resistance Rₖ includes a resistance of the porous wire 14a and the LTO layer 14b of the reference electrode 14 and a resistance of the porous wire 15a and the Cu layer 15b of the negative electrode surface potential measurement electrode 15.

Preferably, the internal resistance Rₖ may be determined using electrochemical impedance spectroscopy (EIS). The internal resistance Rₖ corresponds to a resistance at a point at which the EIS graph (curve) meets the x axis in the EIS measurement results of the test unit cell.

In addition to the EIS, the internal resistance Rₖ of the test unit cell may be determined by any other known method. Accordingly, the present disclosure is not limited by the method for measuring the internal resistance Rₖ.

Subsequently, in step S60, the negative electrode surface potential profile is corrected using the voltage component Rₖ*Iₖ due to the internal resistance Rₖ. Preferably, the negative electrode surface potential profile may be corrected by subtracting the voltage component Rₖ*Iₖ due to the internal resistance Rₖ from the negative electrode surface potential profile.

Subsequently, in step S70, a reference State Of Charge SOC_{refer,k} corresponding to the lithium deposition boundary potential is determined in the negative electrode surface potential profile corrected for the voltage component Rₖ*Iₖ due to the internal resistance Rₖ. Here, the lithium deposition boundary potential may be 0V. In some cases, the lithium deposition boundary potential may be set to be slightly higher than 0V, taking the safety margin into account.

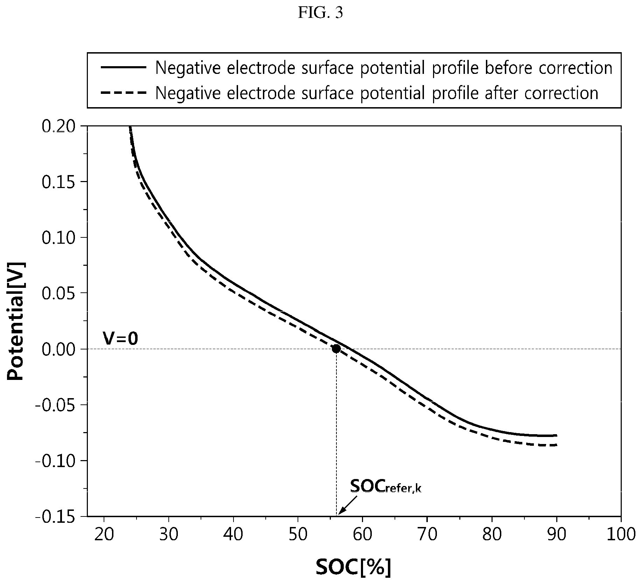

FIG. 3 is a graph showing the negative electrode surface potential profile (solid line) according to SOC determined in step S40 and the negative electrode surface potential profile (dashed line) after the correction of the voltage component Rₖ*Iₖ due to the internal resistance Rₖ in step S60 according to an embodiment of the present disclosure.

Referring to FIG. 3, the negative electrode surface potential profile (dashed line) corrected for the voltage component Rₖ*Iₖ due to the internal resistance Rₖ has a downward shift pattern from the negative electrode surface potential profile (solid line) before the correction. It is because the negative electrode surface potential decreases as much as the voltage component Rₖ*Iₖ due to the internal resistance Rₖ.

Additionally, in the negative electrode surface potential profile (dashed line), the reference State of Charge SOC_{refer,k} corresponding to the lithium deposition boundary potential may be a SOC of a point at which the negative electrode surface potential profile (dashed line) and the straight line V=0 cross each other.

After the step S70, step S80 is performed.

In the step S80, after the test unit cell is discharged, a first charging profile according to is determined by performing CC charging with the set charging current C-rate Iₖ in the SOC range until the reference State of Charge SOC_{refer,k} and performing constant voltage (CV) charging constantly maintaining a voltage between the positive electrode 11 and the negative electrode 12 in the SOC range after the reference State of Charge SOC_{refer,k}. To control the CV charging, the positive electrode tab 11c of the positive electrode 11 and the negative electrode tab 12c of the negative electrode 12 may be connected to a voltage detection probe of the charge tester. The charge tester performs CV charging under the condition that voltage applied between the positive electrode tab 11c and the negative electrode tab 12c is constantly maintained. During the CV charging, the internal resistance of the test unit cell gradually increases with the increasing of SOC, and thus the charging current gradually decreases according to the Ohm's law (I=V/R, V is constant).

Subsequently, in step S90, after the test unit cell is discharged again, a second charging profile according to SOC is determined by performing CC charging on the test unit cell in the SOC range until the reference State of Charge SOC_{refer,k}, and performing CV charging constantly maintaining a voltage between the positive electrode 11 and the negative electrode surface in the SOC range after the reference State of Charge SOC_{refer,k}. To control the CV charging, the positive electrode tab 11c of the positive electrode 11 and the negative electrode surface potential measurement electrode 15 may be connected to the voltage detection probe of the charge tester. Alternatively, the reference electrode 14 and the negative electrode surface potential measurement electrode 15 may be connected to the voltage detection probe of the charge tester. The charge tester performs CV charging under the condition that voltage applied between the positive electrode tab 11c or the reference electrode 14 and the negative electrode surface potential measurement electrode 15 is constantly maintained. During the CV charging, the internal resistance of the test unit cell gradually increases with the increasing of SOC, and thus the charging current gradually decreases according to the Ohm's law (I=V/R, V is constant).

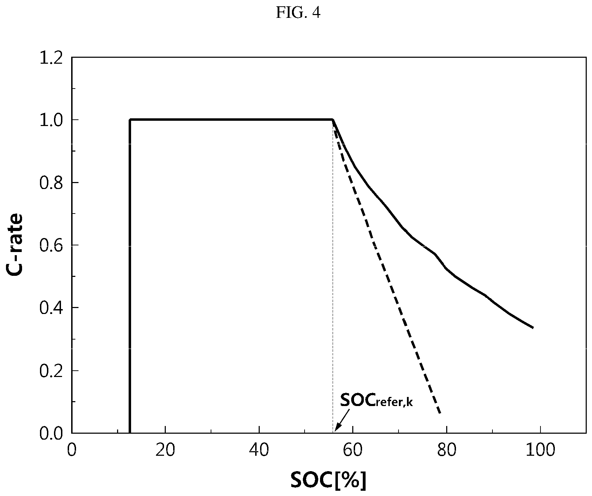

FIG. 4 is a graph showing an example of a first charging profile (dashed line) and a second charging profile (solid line) according to an embodiment of the present disclosure.

Referring to FIG. 4, the first charging profile (dashed line) and the second charging profile (solid line) are substantially the same in the charging range until the reference State of Charge SOC_{refer,k}. Accordingly, in the charging range until the reference State of Charge SOC_{refer,k}, the dashed line overlies the solid line, so the first charging profile (dashed line) and the second charging profile (solid line) cannot be distinguished from each other. However, the two profiles show different changes in the charging range after the reference State of Charge SOC_{refer,k}. That is, the decline rate of the charging current C-rate of the second charging profile (solid line) is slower than the decline rate of the charging current C-rate of the first charging profile (dashed line). It is because the second charging profile (solid line) is obtained through CV charging under the condition that the voltage between the positive electrode 11 and the negative electrode surface (the active material layer) is constantly maintained.

After the step S90, step S100 is performed.

In the step S100, a battery including a plurality of cells is fabricated. The plurality of cells is made of the same material as the test unit cell. That is, the plurality of cells and the test unit cell have substantially the same type of the positive electrode current collector plate, the negative electrode current collector plate, the positive electrode active material, the negative electrode active material, the separator and the electrolyte. Additionally, the battery includes the same electrolyte as that used in the test unit cell.

The battery may be a pouch type battery. The plurality of cells is received in the packaging made from the pouch film. In another example, the battery may be a prismatic or cylindrical battery. In the battery, the plurality of cells may be connected in parallel.

Each of the plurality of cells has a structure in which the negative electrode/the separator/the positive electrode are laminated. A stack-folding type electrode assembly may be formed by arranging the plurality of cells on a separation film at regular intervals and winding the separation film from one side to the other.

A variety of modifications may be made to the structure of the electrode assembly. In an example, the electrode assembly may be a jelly-roll (winding type) electrode assembly in which a long sheet type positive electrode and a long sheet type negative electrode are wound with a separator interposed therebetween or a stack type electrode assembly in which a plurality of positive electrodes and a plurality of negative electrodes cut into a predetermined size are stacked in a sequential order with separators interposed therebetween. It is obvious that any electrode assembly structure known in the technical field pertaining to the present disclosure may be adopted without limitation.

After the step S100, step S110 is performed.

In the step S110, a third charging profile according to SOC is determined by performing CC charging on the battery including the plurality of cells until the reference State of Charge SOC_{refer,k} and performing CV charging constantly maintaining a voltage between the positive electrode and the negative electrode of the battery in the SOC range after the reference State of Charge SOC_{refer,k}. The magnitude of the charging current during the CC charging corresponds to the set charging current C-rate Iₖ.

Subsequently, in step S120, a charging profile of the battery is determined by correcting the third charging profile using a difference between the first charging profile and the second charging profile.

Preferably, in step S120, the charging profile of the battery may be determined by correcting the third charging profile with an addition of a difference profile between the first charging profile and the second charging profile to a part of the third charging profile after the reference State of Charge SOC_{refer,k}.

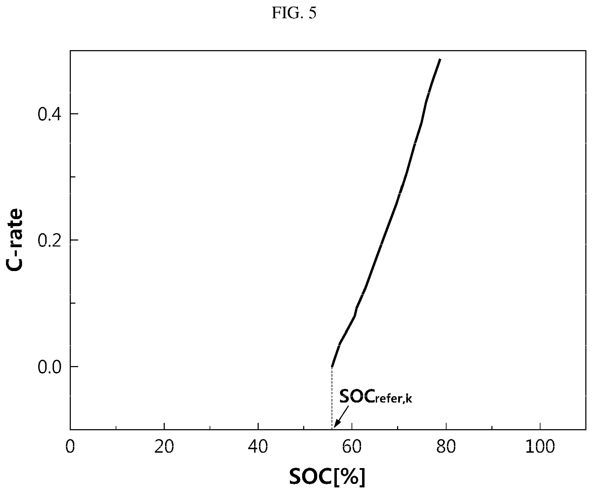

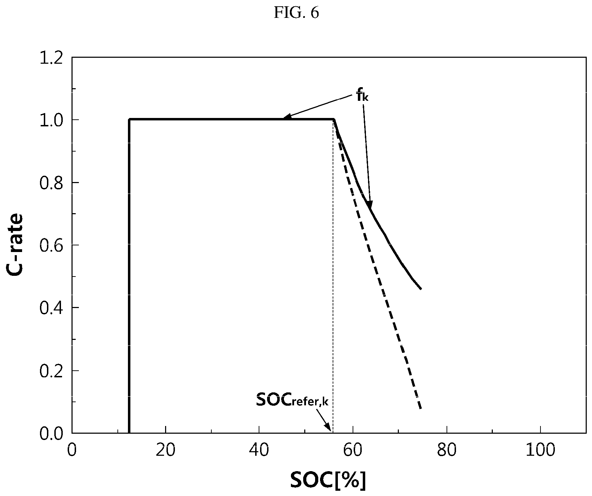

FIG. 5 is a graph showing the difference profile obtained by subtracting the first charging profile (dashed line in FIG. 4) from the second charging profile (solid line in FIG. 4) according to an embodiment of the present disclosure. Additionally, FIG. 6 is a graph showing the third charging profile obtained by CC-CV charging of the battery and the charging profile fₖ of the battery obtained by correcting the third charging profile using the difference profile according to an embodiment of the present disclosure.

Referring to FIG. 5, the difference profile is only obtained in the charging range after the reference State of Charge SOC_{refer,k}. It is because the first charging profile and the second charging profile are substantially the same in the charging range before the reference State of Charge SOC_{refer,k}.

Referring to FIG. 6, the third charging profile obtained through CC-CV charging of the battery including the plurality of cells is depicted in the solid line in the charging range until the reference State of Charge SOC_{refer,k}, and in the dashed line in the charging range after the reference State of Charge SOC_{refer,k}. The charging profile fₖ of the battery is obtained by correcting only the charging range after the reference State of Charge SOC_{refer,k} among all range of the third charging profile. That is, the charging profile fₖ of the battery may be obtained by adding the difference profile of FIG. 5 to a profile part of the third charging profile (dashed line) in the charging range after the reference State of Charge SOC_{refer,k}. Accordingly, the charging profile fₖ of the battery includes the charging profile until the reference State of Charge SOC_{refer,k} and the solid line profile after the reference State of Charge SOC_{refer,k}.

As shown in FIG. 6, the charging profile fₖ of the battery has a smaller decline slope of the charging current C-rate in the charging range after the reference State of Charge SOC_{refer,k} than the decline slope of the charging current C-rate applied during ordinary CV charging. Accordingly, while preventing lithium deposition at the negative electrode in the latter stage of charging, it is possible to reduce the decline rate of the charging current C-rate compared to the related art, thereby reducing the charging time as much.

After the step S120, step S130 is performed.

In the step S 130, the index k is increased by 1, and the step reverts to S30.

Accordingly, the charging current C-rate Iₖ and the charging temperature Tₖ of CC charging are re-set to different conditions, and steps S40 to S 120 are performed.

When the above-described series of steps is repeatedly performed, a plurality of charging profiles fₖ of the battery may be determined under the condition of different charging current C-rates Iₖ and different charging temperatures Tₖ.

When charging tests are repeatedly performed using one test unit cell, the accuracy of the charging profile fₖ may reduce as the test unit cell degrades.

Accordingly, it is desirable to fabricate a plurality of test unit cells, and determine the charging profile fₖ of the battery by performing the above-described steps using a new test unit cell each time the charging current C-rate Iₖ and the charging temperature Tₖ of CC charging are set to different conditions.

The charging profile fₖ of the battery corresponding to the charging current C-rate Iₖ and the charging temperature Tₖ of CC charging may be used as below in the charging of the battery.

First, the charging profile fₖ of the battery corresponding to the charging current C-rate Iₖ and the charging temperature Tₖ of CC charging may be stored in a storage medium of a battery charging system as lookup information.

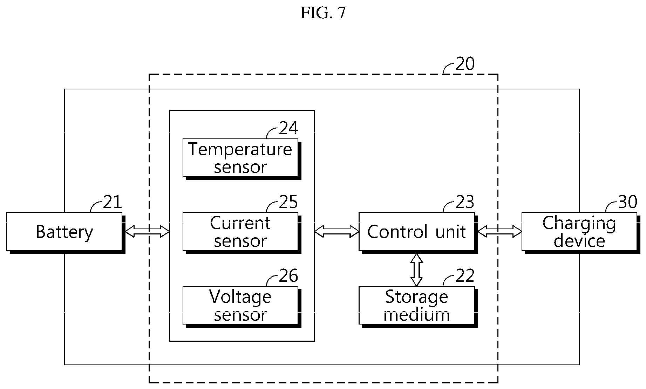

FIG. 7 is an architecture diagram showing an example of the battery charging system 20 according to an embodiment of the present disclosure.

Referring to FIG. 7, the battery charging system 20 is a computer system configured to control the charge and discharge of the battery 21, calculate and manage the SOC and state of health (SOH) of the battery 21, and detect an abnormal condition of the battery 21 such as overcharge, overdischarge, overcurrent or the like.

Preferably, the battery charging system 20 may be incorporated into a control system of a load on which the battery 21 is mounted, for example, a control system of an electric vehicle.

The storage medium 22 is not limited to a particular type, and may include any storage medium capable of recording and erasing data and/or information. In an example, the storage medium 22 may be RAM, ROM, register, flash memory, hard disk or a magnetic recording medium.

The storage medium 22 may be electrically connected to the control unit 23, for example, via a data bus to allow the control unit 23 to make access.

The storage medium 22 stores and/or updates and/or erases and/or transmits programs including the control logics executed by the control unit 23 and/or data generated when the control logics are executed and/or preset data or lookup information/tables.

When the load device (for example, an electric vehicle) on which the battery 21 is mounted is connected to the charging device 30 to charge the battery, the control unit 23 measures the temperature of the battery 21 through a temperature sensor 24 and sets the measured temperature as the charging temperature Tₖ.

Additionally, the control unit 23 may select the charging current C-rate Iₖ to be applied during CC charging of the battery 21. In an example, the control unit 23 may select the charging current C-rate Iₖ of CC charging corresponding to the current SOH of the battery 21 by referring to the lookup information defining the charging current C-rate Iₖ of CC charging for each SOH of the battery 21. When a deterioration degree of the SOH is high, the charging current C-rate Iₖ is low, and when a deterioration degree of the SOH is low, the charging current C-rate Iₖ is high. The SOH of the battery 21 may be pre-calculated and recorded in the storage medium 22 for reference.

In another example, the control unit 23 may select the charging current C-rate Iₖ of CC charging depending on whether the type of the charging device 30 is a fast charger or a regular charger.

When the charging device 30 is a fast charger, the control unit 23 may select a high charging current C-rate Iₖ. On the contrary, when the charging device 30 is a regular charger, the control unit 23 may select a low charging current C-rate Iₖ.

When the charging current C-rate Iₖ and the charging temperature Tₖ of CC charging are determined, the control unit 23 identifies the reference State of Charge SOC_{refer,k} and the charging profile fₖ of the battery 21 corresponding to the charging temperature Tₖ and the charging current C-rate Iₖ by referring to the lookup information pre-stored in the storage medium 22.

The reference State of Charge SOC_{refer,k} and the charging profile fₖ set for each charging temperature Tₖ and each charging current C-rate Iₖ of CC charging may be pre-stored in the storage medium 22 as the lookup information.

The charging profile fₖ includes a CC charging range in which the charging current C-rate is constant in the charging range until the reference State of Charge SOC_{refer,k}, and a C-rate decline range in which the charging current C-rate gradually decreases in the charging range after the reference State of Charge SOC_{refer,k}. The C-rate decline range is the charging range in which voltage between the negative electrode surface and the positive electrode is constantly maintained.

When the reference State of Charge SOC_{refer,k} and the charging profile fₖ are determined, the control unit 23 may charge the battery 21 according to the CC charging range and the C-rate decline range of the charging profile fₖ using the charging device 30.

To this end, the control unit 23 may transmit a CC charging message including the magnitude of the charging current corresponding to the charging current C-rate Iₖ to the charging device 30. The CC charging message may be transmitted through a communication line included in a charging cable. When the charging device 30 receives the CC charging message, the charging device 30 may apply the charging current corresponding to the charging current C-rate Iₖ to the battery 21.

When the CC charging starts, the control unit 23 may determine the magnitude of the charging current using a current sensor 25 and determine the current SOC of the battery 21 by accumulating the charging current by ampere counting. Additionally, the control unit 23 periodically transmits the CC charging message to the charging device 30 until the SOC of the battery 21 reaches the reference State of Charge SOC_{refer,k}. The charging device 30 continuously maintains the CC charging mode while the charging device 30 receives the CC charging message.

Meanwhile, when the SOC of the battery 21 reaches the reference State of Charge SOC_{refer,k}, the control unit 23 changes from the CC charging mode to a C-rate decline mode, determines the charging current C-rate corresponding to the current SOC by referring to the charging profile fₖ, and transmits the CV charging message including the magnitude of the charging current corresponding to the determined charging current C-rate to the charging device 30. When the CV charging message is transmitted, the charging device 30 identifies the magnitude of the charging current included in the message and applies the charging current corresponding to the identified magnitude of the charging current to the battery 21.

The control unit 23 updates the current SOC again by continuously accumulating the charging current during the charging of the battery 21 in the C-rate decline range, determines the charging current C-rate corresponding to the current SOC again by referring to the charging profile fₖ and transmits the CV charging message including the magnitude of the charging current corresponding to the determined charging current C-rate to the charging device 30.

When the CV charging message is transmitted, the charging device 30 identifies the magnitude of the charging current included in the message, and applies the charging current corresponding to the identified magnitude of the charging current to the battery 21.

When the charging process is repeatedly performed, the SOC of the battery 21 continuously increases and the charging current C-rate gradually decreases. When the charging current C-rate determined by referring to the charging profile fₖ reduces down to a preset value, the control unit 23 transmits a charging termination message to the charging device 30. When the charging device 30 receives the charging termination message, the charging device 30 does not apply the charging current to the battery 21 any longer.

In an example, when the charging current C-rate corresponding to the current SOC reduces down to a preset C-rate as the charging termination condition, the control unit 23 may terminate the charging.

In another example, the control unit 23 may measure the voltage of the battery 21 using a voltage sensor 26, and terminate the charging when the voltage of the battery 21 reaches the full charge voltage.

In still another example, when the SOC of the battery 21 reaches a preset level, the control unit 23 may terminate the charging.

The control unit 23 may selectively include a processor, application-specific integrated circuit (ASIC), a chipset, a logic circuit, register, a communication modem, a data processing device or the like known in the corresponding technical field to execute the above-described control logics. Additionally, when the control logics are implemented in software, the control unit 23 may be designed as a collection of program modules. In this instance, the program modules may be stored in memory and executed by the processor. The memory may be inside or outside of the processor, and may be connected to the processor with a variety of known computer components. Additionally, the memory may be included in the storage medium 22 of the present disclosure. Additionally, the memory refers collectively to devices that store information irrespective of device type and does not refer to a particular memory device.

At least one of the control logics of the control unit 23 may be combined together, and the combined control logics may be written in computer-readable code and recorded in computer-readable recording media. The recording media are not limited to a particular type and may include any medium that can be accessed by the processor included in the computer. For example, the recording media include at least one selected from the group consisting of ROM, RAM, register, CD-ROM, magnetic tape, hard disk, floppy disk and an optical data recording device. Additionally, the code may be stored and executed in distributed computers connected via a network. Additionally, the functional programs, code and code segments for implementing the combined control logics can be easily inferred by programmers in the technical field pertaining to the present disclosure.

In describing the various embodiments of the present disclosure, the components called '~unit' should be understood as components that are functionally divided rather than physically. Accordingly, each component may be selectively combined with other component or split into subcomponents for the efficient execution of the control logic(s). However, it is obvious to those skilled in the art that even though the components are combined or split, the combined or split components should be interpreted as falling within the scope of the present disclosure in case that the identity of function is acknowledged.

While the present disclosure has been hereinabove described with regard to a limited number of embodiments and drawings, the present disclosure is not limited thereto and it is obvious to those skilled in the art that various modifications and changes may be made thereto within the technical aspects of the present disclosure and the appended claims and equivalents thereof.

## Claims

1. A method for determining a charging current profile of a battery, comprising:
(a) determining (S70) a reference state of charge, SOC, corresponding to a lithium deposition boundary potential in a negative electrode surface potential profile according to SOC obtained through constant current, CC, charging of a test unit cell;
(b) determining (S80) a first charging current profile according to SOC by performing CC charging on the test unit cell in the SOC range until the reference SOC, and performing constant voltage, CV, charging constantly maintaining a voltage between a negative terminal and a positive terminal in the SOC range after the reference SOC;
(c) determining (S90) a second charging current profile according to SOC by performing CC charging on the test unit cell in the SOC range until the reference SOC, and performing CV charging constantly maintaining a voltage between the negative electrode surface and the positive terminal in the SOC range after the reference SOC;
(d) determining (S110) a third charging current profile according to SOC by performing CC charging on a battery including a plurality of cells until the reference SOC and performing CV charging constantly maintaining a voltage between the negative terminal and the positive terminal after the reference SOC; and
(e) determining (S120) a charging current profile of the battery by correcting the third charging profile by adding a difference profile between the first and second charging profiles to a part of the third charging profile after the reference SOC .

2. The method for determining the charging current profile of the battery according to claim 1, wherein the test unit cell is a 4-pole cell, and
wherein the 4-pole cell includes:
at least one positive electrode and at least one negative electrode;
a reference electrode to provide a reference potential for the surface potential of the negative electrode; and
a negative electrode surface potential measurement electrode in contact with the surface of the negative electrode.

3. The method for determining the charging current profile of the battery according to claim 2, wherein the step (a) comprises:
(a1) determining (S40) the negative electrode surface potential profile according to SOC by measuring a negative electrode surface potential through the reference electrode and the negative electrode surface potential measurement electrode during the CC charging of the test unit cell;
(a2) measuring (S50) an internal resistance present in a negative electrode surface potential measurement pathway; and
(a3) correcting (S60) the negative electrode surface potential profile using a voltage component due to the internal resistance.

4. The method for determining the charging current profile of the battery according to claim 3, wherein the internal resistance is determined by electrochemical impedance spectroscopy, EIS.

5. The method for determining the charging current profile of the battery according to claim 3, wherein the step (a3) comprises correcting the negative electrode surface potential profile by subtracting the voltage component due to the internal resistance from the negative electrode surface potential profile.

6. The method for determining the charging current profile of the battery according to claim 1, wherein in the step (a), the lithium deposition boundary potential is 0 V.

7. The method for determining the charging current profile of the battery according to claim 1, wherein the charging profile is independently determined for each of a plurality of charging current C-rate and charging temperature conditions by repeatedly performing the steps (a) to (e) with varying charging current C-rate and charging temperature conditions of the CC charging.

8. A battery charging system (20), comprising:
a storage medium (22) to store a charging current profile of a battery (21) according to a charging current C-rate; and
a control unit (23) operably coupled to the storage medium (22),
wherein the control unit (23) is configured to:
set the charging current C-rate of the CC charging, and
determine:
(a) a reference state of charge, SOC, corresponding to a lithium deposition boundary potential in a negative electrode surface potential profile according to SOC obtained through constant current, CC, charging of a test unit cell;
(b) a first charging current profile according to SOC by performing CC charging on the test unit cell in the SOC range until the reference SOC, and performing constant voltage, CV, charging constantly maintaining a voltage between a negative terminal and a positive terminal in the SOC range after the reference SOC;
(c) a second charging current profile according to SOC by performing CC charging on the test unit cell in the SOC range until the reference SOC, and performing CV charging constantly maintaining a voltage between the negative electrode surface and the positive terminal in the SOC range after the reference SOC;
(d) a third charging current profile according to SOC by performing CC charging on a battery including a plurality of cells until the reference SOC and performing CV charging constantly maintaining a voltage between the negative terminal and the positive terminal after the reference SOC; and
(e) a charging current profile of the battery (21) by correcting the third charging profile by adding a difference profile between the first and second charging profiles to a part of the third charging profile after the reference SOC

9. The system (20) according to claim 8, further comprising
a temperature sensor (24) to measure a temperature of the battery (21);
wherein the storage medium (22) is further configured to store a charging temperature of constant current, CC, charging; and wherein
the control unit (23) is further coupled to the temperature sensor (24) and is further configured to set the battery temperature measured through the temperature sensor (24) as the charging temperature.

10. The battery charging system (20) according to claim 9, wherein the control unit (23) is further configured to:
determine an SOC of the battery (21), and
determine the charging current C-rate corresponding to the SOC by referring to the charging profile, and
apply a charging current corresponding to the determined charging current C-rate using a charging device (30) to the battery (21).

## Patentansprüche

1. Verfahren zum Bestimmen eines Ladestromprofils einer Batterie, umfassend:
(a) Bestimmen (S70) eines Referenzladezustands, SOC -state of charge, entsprechend einem Lithiumabscheidungsgrenzpotential in einem Negative-Elektrode-Oberflächenpotentialprofil gemäß einem durch ein Laden mit einem konstanten Strom, CC - constant current, einer Testeinheitszelle erhaltenen SOC;
(b) Bestimmen (S80) eines ersten Ladestromprofils gemäß einem SOC durch ein Durchführen eines CC-Ladens an der Testeinheitszelle in dem SOC-Bereich bis zu dem Referenz-SOC und ein Durchführen eines Ladens mit einer konstanten Spannung, CV - constant voltage, welches eine Spannung zwischen einem negativen Anschluss und einem positiven Anschluss konstant hält, in dem SOC-Bereich nach dem Referenz-SOC;
(c) Bestimmen (S90) eines zweiten Ladestromprofils gemäß einem SOC durch ein Durchführen eines CC-Ladens an der Testeinheitszelle in dem SOC-Bereich bis zu dem Referenz-SOC und ein Durchführen eines CV-Ladens, welches eine Spannung zwischen der Negative-Elektrode-Oberfläche und dem positiven Anschluss konstant hält, in dem SOC-Bereich nach dem Referenz-SOC;
(d) Bestimmen (S110) eines dritten Ladestromprofils gemäß einem SOC durch ein Durchführen eines CC-Ladens an einer Batterie, welche eine Mehrzahl von Zellen umfasst, bis zu dem Referenz-SOC und ein Durchführen eines CV-Ladens, welches eine Spannung zwischen dem negativen Anschluss und dem positiven Anschluss konstant hält, nach dem Referenz-SOC; und
(e) Bestimmen (S120) eines Ladestromprofils der Batterie durch ein Korrigieren des dritten Ladeprofils durch ein Addieren eines Differenzprofils zwischen dem ersten und dem zweiten Ladeprofil zu einem Teil des dritten Ladeprofils nach dem Referenz-SOC.

2. Verfahren zum Bestimmen des Ladestromprofils der Batterie nach Anspruch 1, wobei die Testeinheitszelle eine 4-Pol-Zelle ist und
wobei die 4-Pol-Zelle umfasst:
wenigstens eine positive Elektrode und wenigstens eine negative Elektrode;
eine Referenzelektrode zum Bereitstellen eines Referenzpotentials für das Oberflächenpotential der negativen Elektrode; und
eine Negative-Elektrode-Oberflächenpotential-Messelektrode in Kontakt mit der Oberfläche der negativen Elektrode.

3. Verfahren zum Bestimmen des Ladestromprofils der Batterie nach Anspruch 2, wobei der Schritt (a) umfasst:
(a1) Bestimmen (S40) des Negative-Elektrode-Oberflächenpotentialprofils gemäß einem SOC durch ein Messen eines Negative-Elektrode-Oberflächenpotentials durch die Referenzelektrode und die Negative-Elektrode-Oberflächenpotential-Messelektrode während des CC-Ladens der Testeinheitszelle;
(a2) Messen (S50) eines Innenwiderstands, welcher in einem Negative-Elektrode-Oberflächenpotential-Messweg vorhanden ist; und
(a3) Korrigieren (S60) des Negative-Elektrode-Oberflächenpotentialprofils unter Verwendung einer Spannungskomponente aufgrund des Innenwiderstands.

4. Verfahren zum Bestimmen des Ladestromprofils der Batterie nach Anspruch 3, wobei der Innenwiderstand durch eine elektrochemische Impedanzspektroskopie, EIS - electrochemical impedance spectroscopy, bestimmt wird.

5. Verfahren zum Bestimmen des Ladestromprofils der Batterie nach Anspruch 3, wobei der Schritt (a3) ein Korrigieren des Negative-Elektrode-Oberflächenpotentialprofils durch ein Subtrahieren der Spannungskomponente aufgrund des Innenwiderstands von dem Negative-Elektrode-Oberflächenpotentialprofil umfasst.

6. Verfahren zum Bestimmen des Ladestromprofils der Batterie nach Anspruch 1, wobei in dem Schritt (a) das Lithiumabscheidungsgrenzpotential 0 V ist.

7. Verfahren zum Bestimmen des Ladestromprofils der Batterie nach Anspruch 1, wobei das Ladeprofil für jede einer Mehrzahl von Ladestrom-C-Rate- und Ladetemperatur-Bedingungen unabhängig bestimmt wird, durch ein wiederholtes Durchführen der Schritte (a) bis (e) mit variierenden Ladestrom-C-Rate- und Ladetemperatur-Bedingungen des CC-Ladens.

8. Batterieladesystem (20), umfassend:
ein Speichermedium (22) zum Speichern eines Ladestromprofils einer Batterie (21) gemäß einer Ladestrom-C-Rate; und
eine Steuereinheit (23), welche betriebsmäßig mit dem Speichermedium (22) gekoppelt ist,
wobei die Steuereinheit (23) eingerichtet ist, zum:
Festlegen der Ladestrom-C-Rate des CC-Ladens und
Bestimmen:
(a) eines Referenzladezustands, SOC - state of charge, entsprechend einem Lithiumabscheidungsgrenzpotential in einem Negative-Elektrode-Oberflächenpotentialprofil gemäß einem durch ein Laden mit einem konstanten Strom, CC - constant current, einer Testeinheitszelle erhaltenen SOC;
(b) eines ersten Ladestromprofils gemäß einem SOC durch ein Durchführen eines CC-Ladens an der Testeinheitszelle in dem SOC-Bereich bis zu dem Referenz-SOC und ein Durchführen eines Ladens mit einer konstanten Spannung, CV - constant voltage, welches eine Spannung zwischen einem negativen Anschluss und einem positiven Anschluss konstant hält, in dem SOC-Bereich nach dem Referenz-SOC;
(c) eines zweiten Ladestromprofils gemäß einem SOC durch ein Durchführen eines CC-Ladens an der Testeinheitszelle in dem SOC-Bereich bis zu dem Referenz-SOC und ein Durchführen eines CV-Ladens, welches eine Spannung zwischen der Negative-Elektrode-Oberfläche und dem positiven Anschluss konstant hält, in dem SOC-Bereich nach dem Referenz-SOC;
(d) eines dritten Ladestromprofils gemäß einem SOC durch ein Durchführen eines CC-Ladens an einer Batterie, welche eine Mehrzahl von Zellen umfasst, bis zu dem Referenz-SOC und ein Durchführen eines CV-Ladens, welches eine Spannung zwischen dem negativen Anschluss und dem positiven Anschluss konstant hält, nach dem Referenz-SOC; und
(e) eines Ladestromprofils der Batterie (21) durch ein Korrigieren des dritten Ladeprofils durch ein Addieren eines Differenzprofils zwischen dem ersten und dem zweiten Ladeprofil zu einem Teil des dritten Ladeprofils nach dem Referenz-SOC.

9. System (20) nach Anspruch 8, ferner umfassend:
einen Temperatursensor (24) zum Messen einer Temperatur der Batterie (21);
wobei das Speichermedium (22) ferner dazu eingerichtet ist, eine Ladetemperatur eines Ladens mit einem konstanten Strom, CC - constant current, zu speichern; und wobei
die Steuereinheit (23) ferner mit dem Temperatursensor (24) gekoppelt ist und ferner dazu eingerichtet ist, die durch den Temperatursensor (24) gemessene Batterietemperatur als die Ladetemperatur festzulegen.

10. Batterieladesystem (20) nach Anspruch 9, wobei die Steuereinheit (23) ferner eingerichtet ist, zum:
Bestimmen eines SOC der Batterie (21) und
Bestimmen der Ladestrom-C-Rate entsprechend dem SOC durch Bezugnahme auf das Ladeprofil und
Anlegen eines Ladestroms entsprechend der bestimmten Ladestrom-C-Rate unter Verwendung einer Ladevorrichtung (30) an die Batterie (21).

## Revendications

1. Procédé de détermination d'un profil de courant de charge d'une batterie, comprenant :
(a) la détermination (S70) d'un état de charge de référence, SOC, correspondant à un potentiel limite de dépôt de lithium dans un profil de potentiel de surface d'électrode négative selon le SOC obtenu par le biais d'une charge à courant constant, CC, d'une cellule d'unité de test ;
(b) la détermination (S80) d'un premier profil de courant de charge selon le SOC en réalisant une charge CC sur la cellule d'unité de test dans la plage de SOC jusqu'au SOC de référence, et en réalisant une charge à tension constante, CV, en maintenant constamment une tension entre une borne négative et une borne positive dans la plage de SOC après le SOC de référence ;
(c) la détermination (S90) d'un deuxième profil de courant de charge selon le SOC en réalisant une charge CC sur la cellule d'unité de test dans la plage de SOC jusqu'au SOC de référence, et en réalisant une charge CV en maintenant constamment une tension entre la surface d'électrode négative et la borne positive dans la plage de SOC après le SOC de référence ;
(d) la détermination (S110) d'un troisième profil de courant de charge selon le SOC en réalisant une charge CC sur une batterie comportant une pluralité de cellules jusqu'au SOC de référence et en réalisant une charge CV en maintenant constamment une tension entre la borne négative et la borne positive après le SOC de référence ; et
(e) la détermination (S120) d'un profil de courant de charge de la batterie en corrigeant le troisième profil de charge en ajoutant un profil de différence entre les premier et deuxième profils de charge à une partie du troisième profil de charge après le SOC de référence.

2. Procédé de détermination du profil de courant de charge de la batterie selon la revendication 1, dans lequel la cellule d'unité de test est une cellule à 4 pôles, et dans lequel la cellule à 4 pôles comporte :
au moins une électrode positive et au moins une électrode négative ;
une électrode de référence pour fournir un potentiel de référence pour le potentiel de surface de l'électrode négative ; et
une électrode de mesure de potentiel de surface d'électrode négative en contact avec la surface de l'électrode négative.

3. Procédé de détermination du profil de courant de charge de la batterie selon la revendication 2, dans lequel l'étape (a) comprend :
(a1) la détermination (S40) du profil de potentiel de surface d'électrode négative selon le SOC en mesurant un potentiel de surface d'électrode négative par le biais de l'électrode de référence et l'électrode de mesure de potentiel de surface d'électrode négative pendant la charge CC de la cellule d'unité de test ;
(a2) la mesure (S50) d'une résistance interne présente dans un trajet de mesure de potentiel de surface d'électrode négative ; et
(a3) la correction (S60) du profil de potentiel de surface d'électrode négative à l'aide d'une composante de tension en raison de la résistance interne.

4. Procédé de détermination du profil de courant de charge de la batterie selon la revendication 3, dans lequel la résistance interne est déterminée par spectroscopie d'impédance électrochimique, EIS.

5. Procédé de détermination du profil de courant de charge de la batterie selon la revendication 3, dans lequel l'étape (a3) comprend la correction du profil de potentiel de surface d'électrode négative en soustrayant la composante de tension en raison de la résistance interne du profil de potentiel de surface d'électrode négative.

6. Procédé de détermination du profil de courant de charge de la batterie selon la revendication 1, dans lequel, dans l'étape (a), le potentiel limite de dépôt de lithium est de 0 V.

7. Procédé de détermination du profil de courant de charge de la batterie selon la revendication 1, dans lequel le profil de charge est déterminé indépendamment pour chacune d'une pluralité de conditions de taux C de courant de charge et de température de charge en réalisant de manière répétée les étapes (a) à (e) avec des conditions de taux C de courant de charge et de température de charge variables de la charge CC.

8. Appareil de gestion de batterie (20), comprenant :
un support de stockage (22) pour stocker un profil de courant de charge d'une batterie (21) selon un taux C de courant de charge ; et
une unité de commande (23) fonctionnellement couplée au support de stockage (22),
dans lequel l'unité de commande (23) est configurée pour :
définir le taux C de courant de charge de la charge CC, et déterminer :
(a) un état de charge de référence, SOC, correspondant à un potentiel limite de dépôt de lithium dans un profil de potentiel de surface d'électrode négative selon le SOC obtenu par une charge à courant constant, CC, d'une cellule d'unité de test ;
(b) un premier profil de courant de charge selon le SOC en réalisant une charge CC sur la cellule d'unité de test dans la plage de SOC jusqu'au SOC de référence, et en réalisant une charge à tension constante, CV, en maintenant constamment une tension entre une borne négative et une borne positive dans la plage de SOC après le SOC de référence ;
(c) un deuxième profil de courant de charge selon le SOC en réalisant une charge CC sur la cellule d'unité de test dans la plage de SOC jusqu'au SOC de référence, et en réalisant une charge CV en maintenant constamment une tension entre la surface d'électrode négative et la borne positive dans la plage de SOC après le SOC de référence ;
(d) un troisième profil de courant de charge selon le SOC en réalisant une charge CC sur une batterie comportant une pluralité de cellules jusqu'au SOC de référence et en réalisant une charge CV en maintenant constamment une tension entre la borne négative et la borne positive après le SOC de référence ; et
(e) un profil de courant de charge de la batterie (21) en corrigeant le troisième profil de charge en ajoutant un profil de différence entre les premier et deuxième profils de charge à une partie du troisième profil de charge après l'état de charge de référence

9. Système (20) selon la revendication 8, comprenant en outre un capteur de température (24) pour mesurer une température de la batterie (21) ; dans lequel le support de stockage (22) est en outre configuré pour stocker une température de charge de charge à courant constant, CC, et dans lequel
l'unité de commande (23) est en outre couplée au capteur de température (24) et est en outre configurée pour définir la température de batterie mesurée par le capteur de température (24) comme température de charge.

10. Système de gestion de batterie (20) selon la revendication 9, dans lequel l'unité de commande (23) est en outre configurée pour :
déterminer un SOC de la batterie (21), et
déterminer le taux C de courant de charge correspondant au SOC en se référant au profil de charge, et
appliquer un courant de charge correspondant au taux C de courant de charge déterminé à l'aide du dispositif de charge (30) sur la batterie (21).
